# EUROPEAN PATENT APPLICATION

(11) **EP 1 432 088 A1**
(43) Date of publication of application: **23.06.2004**
(21) Application number: 02258784.4
(22) Date of filing: 19.12.2002
(51) Int. Cl.: H01S 5/0687

(54) **Semiconductor laser diode wavelength stabilisation**

(71) Applicant: Agilent Technologies, Inc. - a Delaware corporation -, Palo Alto, CA 94303-0870 (US)
(72) Inventor: Meadowcroft, Simon, Ipswich, Suffolk IP1 5PB (GB); Creasey, Chris, Ipswich, Suffolk IP1 5PB (GB)
(74) Representative: Coker, David Graeme

(57) **Abstract**

An optical transmitter is provided that enables transmission at a predetermined wavelength. A beam splitter reflects light into an etalon and the angle of reflection can be controlled such that the output of that etalon is a first periodic signal with a maximum gradient that coincides with each predetermined wavelength. A second beam splitter reflects light into an etalon and the angle of reflection can be controlled such that the output of that etalon is a second periodic signal which has a slightly different free spectral range such that it is possible to determine which of the predetermined wavelengths is being transmitted if the first periodic signal is at a predetermined wavelength.

## Description

The present invention relates to optical transmitters, and in particular to optical transmitters that are suitable for operation over multiple wavelength communication networks.

A recent trend in optical communications networks is to use wavelength division multiplexing (WDM) in order to increase the amount of data that can be transmitted over a single fibre. One of the limitations inherent in WDM systems is that it is necessary to control the wavelengths used in order to prevent inter-channel interference. Furthermore, in order to enable equipment from different manufacturers to be compatible, it is necessary to define wavelength ranges and specific wavelengths for channels within these ranges.

Known techniques used to provide the necessary control of wavelengths have depended upon the measurement of laser parameters as a part of a feedback loop. Unfortunately, these parameters can vary due to changes in laser performance over time and thus these control techniques can be flawed.

According to a first aspect of the present invention there is provided an optical transmitter comprising a semiconductor laser, a wavelength dependent optical resonator), a plurality of beam splitters, a plurality of photodetectors and control means, the optical transmitter being configured to: (a) launch an optical signal from the semiconductor laser; (b) reflect a first portion of the launched optical signal onto the wavelength dependent optical resonator using the first beam splitter such that the first photodetector generates a first periodic signal; (c) reflect a second portion of the launched optical signal onto the wavelength dependent optical resonator using the second beam splitter (24c) such that the second photodetector generates a second periodic signal; (d) analyse the first periodic signal using the control means, the control means controlling the optical signal wavelength such that the optical signal wavelength is substantially equal to one of a set of predetermined wavelengths; and (e) analyse the second periodic signal using the control means, the value of the second periodic signal identifying which of the set of predetermined wavelengths the optical signal wavelength is substantially equal to.

The optical transmitter may additionally comprise a third beam splitter configured to reflect a third portion of the launched optical signal on to a third photodetector to generate a non-periodic signal.

The wavelength dependent optical resonator may have a non-uniform geometry such that the light reflected by the first beam splitter is incident upon a different thickness of the wavelength dependent optical resonator when compared with the light reflected by the second beam splitter. Preferably the wavelength dependent optical resonator is an etalon.

In an alternative arrangement the third second beam splitter may be rotatably mounted to the first beam splitter.

According to a first aspect of the present invention there is provided a method of operating a semiconductor laser at a predefined wavelength, the method comprising the steps of:
(a) launching an optical signal from the semiconductor laser;
(b) reflecting a first portion of the launched optical signal onto the wavelength dependent optical resonator using the first beam splitter, such that the first photodetector generates a first periodic signal; (c) reflecting a second portion of the launched optical signal onto the wavelength dependent optical resonator using the second beam splitter, such that the second photodetector generates a second periodic signal; (d) analysing the first periodic signal using the control means and controlling the optical signal wavelength such that the optical signal wavelength is substantially equal to one of a set of predetermined wavelengths; and (e) analysing the second periodic signal using the control means, the value of the second periodic signal identifying which of the set of predetermined wavelengths the optical signal wavelength is substantially equal to.

The invention will now be described, by way of example only, with reference to the following Figures in which:
Figure 1 shows a schematic depiction of a first embodiment of the present invention;
Figures 2 and 3 show a graphical depiction of the variation of the signals detected at each of the photodetectors with wavelength for the first embodiment of the present invention;
Figure 4 shows an alternative arrangement of the present invention; and
Figure 5 shows a further embodiment of the present invention.

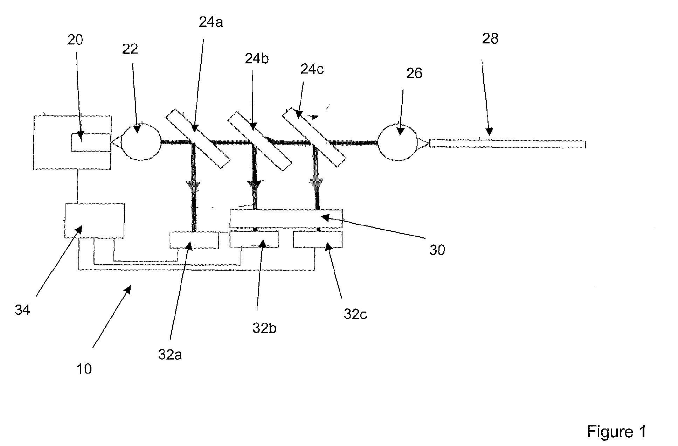

Figure 1 shows a schematic depiction of a first embodiment of the present invention. Optical transmitter 10 comprises semiconductor laser 20, which is arranged to launch light into first focussing means 22. The output of the first focussing means 22 is aligned with beam splitters 24a, 24b and 24c such that there is a main optical axis is defined that passes through all of the beam splitters and into the second focusing means 26. The second focussing means 26 is arranged to focus its output into optical fibre 28, which may form part of an optical communications network (not shown). Beam splitters 24a, 24b and 24c are arranged so as to reflect a small portion of the received light at an angle from the main optical axis. Beam splitter 24a is arranged to reflect light at a constant angle from the main optical axis, such that the light is received by photodetector 32a. The electrical signal generated by photodetector 32a in response to the received light is fed to control means 34, which also has a connection to semiconductor laser 20.

Beam splitters 24b and 24c are secured upon respective rotatable mountings (not shown) such that it is possible to alter the angle at which light is reflected from each of the beam splitters 24b and 24c relative to the main optical axis. Light reflected from beam splitter 24b passes through etalon 30 and is received by photodetector 32b, the electrical output of which is connected to control means 34. Light reflected from beam splitter 24c similarly passes through etalon 30 and is received by photodetector 32c, the electrical output of which is also connected to control means 34.

When the semiconductor laser is emitting light, the majority of the light passes through focussing means 22, beam splitters 24a, 24b and 24c, focussing means 26 and into the optical fibre 28. A small proportion of the launched light is reflected by each of the beam splitters and then detected at the associated photodetector.

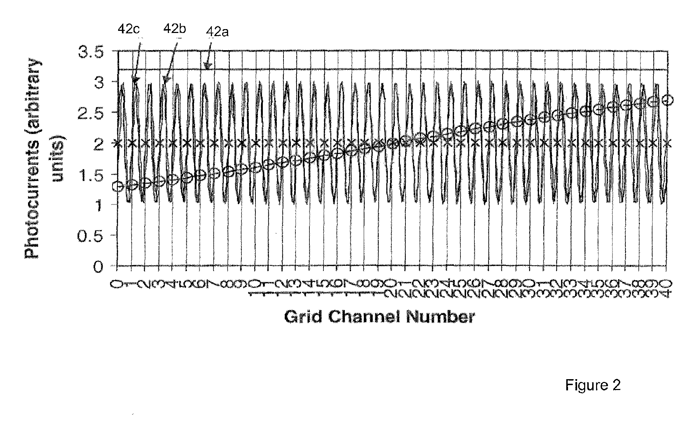

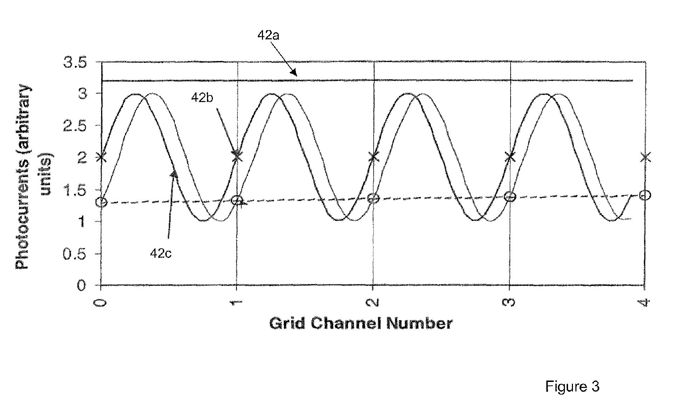

Figures 2 and 3 show a graphical depiction of the variation of the signals detected at each of the photodetectors with wavelength. Signal 42a is generated by photodetector 32a and shows that the output of the semiconductor laser 20 is substantially constant over the wavelength range of interest. Signals 42b and 42c are generated by photodetectors 32b and 32c respectively and are both sinusoidal signals with a slightly different free spectral range (FSR). Figure 3 shows a enlarged view of part of the graph shown in Figure 2, showing the variation of signals 42a, 42b and 42c over the first 4 optical channels.

Signal 42a can be used as a reference to monitor the power of the laser and also to normalise the outputs from photodetectors 42b and 42c. The etalon 30 comprises two partially reflective mirrors arranged around a dielectric material. Light incident on the etalon will be internally reflected a number of times and this gives rise to the periodic variations shown in Figure 2. As beam splitters 24b and 24c can be controlled separately, if they are at different angles to the etalon then the reflected light signals will have different path lengths through the etalon and will hence have different FSRs when received at the respective photodetector.

The angles of beam splitters 24b and 24c relative to the etalon are controlled such that the signals 42b and 42c are in phase at the middle of the wavelength range. By appropriate control of the angle that beam splitter 24b reflects light at, the signal 42b is manipulated such that the start of each sinusoidal cycle of signal 42b substantially coincides with the wavelengths corresponding to the grid channels. The start of each cycle is relatively easy to detect using known signal analysis techniques as there is the greatest rate of change of signal and the second order differential also changes from positive to negative at that point.

Beam splitter 24c can be controlled such that signal 42c has an extra quarter cycle (when compared with signal 42b) and so that signal 42b is in phase with signal 42c at the middle of the wavelength channel grid (i.e. for channel 20 in the example shown in Figure 3. This means that there is a small negative phase difference between signals 42b and 42c for channel 1 and a small positive phase difference between signals 42b and 42c for channel 40, with a substantially linear variation of phase difference as wavelength increases.

Accordingly, it is possible to determine which wavelength, or channel, semiconductor laser 20 is transmitting. If analysis of signal 42b indicates that the laser wavelength in use corresponds to the beginning of a cycle then it is apparent that the laser is operating at a wavelength that corresponds to one of the wavelengths defined by the grid. If the laser is not operating at the beginning of a cycle then it is possible to change the wavelength of the laser (typically by changing the temperature of the laser by varying the power supplied to an electrical heater (or a thermo-electric cooler) that acts upon the laser), until it is operating at the beginning of a cycle.

Once it has been determined that the laser is operating at one of the grid wavelengths it is a simple matter to determine which of these wavelengths it is by measuring the value of signal 42c and comparing the value with the known values of signal 42c for each of the grid channels (alternatively, the difference between signals 42b and 42c may be determined, but this will still lead to the same result.

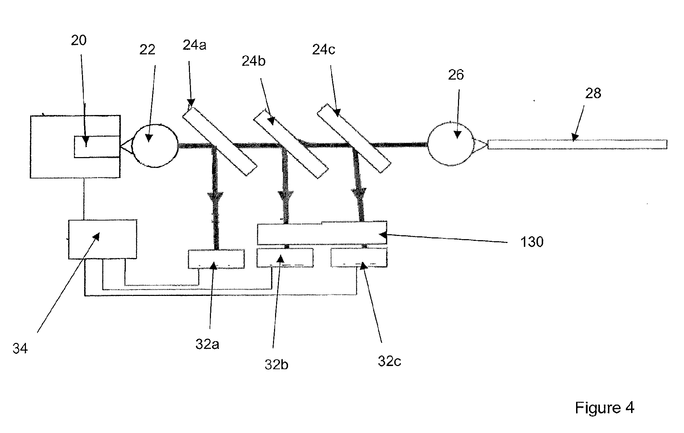

Figure 4 shows an alternative arrangement of the present invention in which etalon 130 has a different thickness for the sections that the light reflected by beam splitters 24b and 24c passes through. The difference in etalon thickness provides a path length difference for the two light signals.

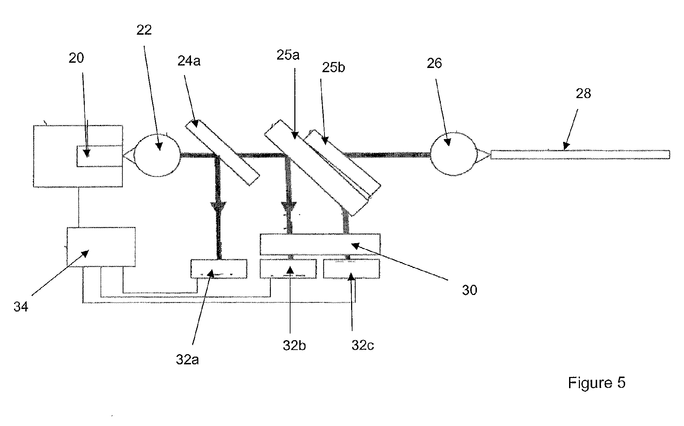

Figure 5 shows a further embodiment of the present invention in which beam splitters 24b and 24c are replace by composite beam splitter 25 which comprises two beam splitting elements 25a and 25b. The first element 25a is angled to reflect light from the main optical axis onto the etalon 30 such that it is received by photodetector 32b. The second element 25b is rotatably mounted on the first element 25a such that the second element can be rotated so as to reflect a fraction of the light that has passed through first element 25a onto the etalon 30 such that it is received by photodetector 32c.

## Claims

1. An optical transmitter (10) comprising a semiconductor laser (20), a wavelength dependent optical resonator (30), a plurality of beam splitters (24a, 24b, 24c), a plurality of photodetectors (32a, 32b, 32c) and control means (34), the optical transmitter being configured to:
(a) launch an optical signal from the semiconductor laser(20);
(b) reflect a first portion of the launched optical signal onto the wavelength dependent optical resonator (30) using the first beam splitter (24b) such that the first photodetector (32b) generates a first periodic signal;
(c) reflect a second portion of the launched optical signal onto the wavelength dependent optical resonator using the second beam splitter (24c) such that the second photodetector (32c) generates a second periodic signal;
(d) analyse the first periodic signal using the control means (30), the control means controlling the optical signal wavelength such that the optical signal wavelength is substantially equal to one of a set of predetermined wavelengths; and
(e) analyse the second periodic signal using the control means, the value of the second periodic signal identifying which of the set of predetermined wavelengths the optical signal wavelength is substantially equal to.

2. An optical transmitter (10) according to claim 1, additionally comprising a third beam splitter (24a) configured to reflect a third portion of the launched optical signal on to a third photodetector (32a) to generate a non-periodic signal.

3. An optical transmitter according to claim 1 or claim 2, wherein the wavelength dependent optical resonator (130) has a non-uniform geometry such that the light reflected by the first beam splitter is incident upon a different thickness of the wavelength dependent optical resonator when compared with the light reflected by the second beam splitter.

4. An optical transmitter according to any preceding claim wherein the wavelength dependent optical resonator is an etalon.

5. An optical transmitter according to any preceding claim wherein the third second beam splitter (25b) is rotatably mounted to the first beam splitter (25a).

6. A method of operating a semiconductor laser at a predefined wavelength, the method comprising the steps of:
(a) launching an optical signal from the semiconductor laser;
(b) reflecting a first portion of the launched optical signal onto the wavelength dependent optical resonator using the first beam splitter, such that the first photodetector generates a first periodic signal;
(c) reflecting a second portion of the launched optical signal onto the wavelength dependent optical resonator using the second beam splitter, such that the second photodetector generates a second periodic signal;
(d) analysing the first periodic signal using the control means and controlling the optical signal wavelength such that the optical signal wavelength is substantially equal to one of a set of predetermined wavelengths; and
(e) analysing the second periodic signal using the control means, the value of the second periodic signal identifying which of the set of predetermined wavelengths the optical signal wavelength is substantially equal to.
